# EUROPEAN PATENT SPECIFICATION

(11) **EP 1 476 949 B1**
(45) Date of publication and mention of the grant of the patent: **01.07.2009**
(21) Application number: 02712490.8
(22) Date of filing: 04.02.2002
(51) Int. Cl.: H04B 1/04, H03F 1/02

(54) **POWER AMPLIFICATION APPARATUS OF PORTABLE TERMINAL**
LEISTUNGSVERSTÄRKUNGSVORRICHTUNG EINES TRAGBAREN ENDGERÄTS
APPAREIL D'AMPLIFICATION DE PUISSANCE POUR TERMINAL PORTABLE

(30) Priority: 01.02.2002 KR 2002005924
(43) Date of publication of application: 17.11.2004
(73) Proprietor: Avago Technologies Wireless IP (Singapore) Pte. Ltd., Singapore 768923 (SG)
(72) Inventor: KWON, Youngwoo 101-1103 Karak Dongbu Centreville, Seoul 138-754 (KR); KIM, Junghyun 403 Woowall Villa, Seoul 151-050 (KR); BAE, Sung-Jun, Kangnam-ku 135-220 Seoul (KR)
(74) Representative: Pingree, Oliver Norman
(86) International application number: PCT/KR2002/000163
(87) International publication number: WO 2003/065599

(56) References cited:
- US-A- 5 420 541
- US-A- 5 880 633
- US-A- 5 886 575
- US-B1- 6 374 092

## Description

### TECHNICAL FIELD

The present invention relates to a power amplifier in a mobile handset used for wireless communication services. More particularly, the invention relates to a power amplifier in a mobile handset that may improve efficiency and linearity.

### BACKGROUND ART

Recently, as mobile handsets used for wireless communication services are becoming smaller and lighter, many studies are conducted to extend talk time of mobile handsets having small-size batteries.

In a conventional mobile handset, the Radio Frequency (RF) power amplifier consumes most of the power consumed by the overall system of the mobile handset. Thus, low efficiency of the RF power amplifier degrades the efficiency of the overall system and accordingly reduces the talk time.

For this reason, much effort has been concentrated on increasing efficiency of the RF power amplifier in the field of power amplification. In one approach, a Doherty-type power amplifier has been introduced recently as a circuit for increasing efficiency of the RF power amplifier.

Unlike other conventional power amplifiers, whose efficiency is low over the low output power range, the Doherty-type power amplifier is designed to maintain an optimum efficiency over a wide output power range. The carrier amplifier, which is composed of relatively small transistors, operates to maintain the optimal efficiency up to a certain low output power level. The peak amplifier operates in cooperative fashion with the carrier amplifier to maintain a high efficiency until the power amplifier, as a whole, produces a maximum output power. When the power amplifier operates within a low power output range, only the carrier amplifier is operational; the peak amplifier, being biased as a class -B or -C, does not operate.

Theoretically, the above-mentioned Doherty-type power amplifier is designed to operate while meeting the linearity specification over an entire output power range and where high efficiency is maintained.

However, as described above, because the Doherty-type power amplifier comprises a carrier amplifier and a peak amplifier that operate with each other, the Doherty-type power amplifier in practice does not satisfy the linearity specification (e.g., in terms of phase or gain characteristics) over the entire output power range where high efficiency is maintained.

In summary, in the above-mentioned Doherty-type power amplifier in the related art, it is difficult to predict the linearity characteristic of the device and it is also difficult to expect any enhancement of linearity in such device because the peak amplifier is biased at a low DC current level such as class -B or -C.

On the other hand, recent researches conducted to increase efficiency of the RF power amplifier have also introduced switch-mode power amplifiers.

The switch-mode power amplifier is designed to be operated differently in various different modes corresponding to its output power levels to improve both efficiency determining the maximum talk time and linearity determining the speech quality. In the switch-mode power amplifier, switches are used to adjust paths of power transmission so that the power amplifier provides its output power, bypassing the power stage if the required output power level is low. In contrast, if high output power level is required, the paths are adjusted through switches so that the power amplifier provides its output power via the power stage.

The switch-mode power amplifier is also known as a bypass switching power amplifier because it bypasses the power stage depending on the required output power level. Generally in a bypass switching power amplifier, a switch for two modes, namely, Single Pole Double Through (SPDT) switch is used at the place where the paths are divided for the different modes to designate the relevant paths. Also, generally, the SPDT switch is used at the place where the respective paths corresponding to the modes join.

The SPDT switch is used in the bypass switching power amplifier at the point where mode branching occurs in order to enhance the isolation level between the respective modes and thus, to optimize the operations in the respective modes.

As described above, because the bypass switching power amplifier in the related art uses a number of switches for operation in various modes depending on the output power levels, output power is decreased due to the losses occurring at the switches of matching units located in front of and behind the power stage. Further, gain and efficiency are decreased and the Adjacent Channel Power Ratio (ACPR) is increased at a given output power level.

The ACPR specification is generally satisfied in a power amplifier through the back-off that operates a power amplifier at an output power level lower than P1dB (1dB Compression Output Power). Thus, in the bypass switching power amplifier, the available output power is limited to some degree due to the losses caused by switching and the back-off operation required for meeting the ACPR specification. This limitation reduces efficiency to some extent, thereby resulting in the reduction in the battery lifetime.

Moreover, the bypass switching power amplifier has disadvantages in that a number of switches that must be used in the amplifier enlarge the size of the amplifier and, further, increase the price of the amplifier.

US 5,886,575 discloses an amplifier having an input and an output, the amplifier output coupled to an input of a Doherty amplifier. The Doherty amplifier includes a control input and a Doherty output. The apparatus further includes a detector having an input coupled to the output of the Doherty amplifier. The detector provides a detected signal at its output, to a controller the controller responding to the detected signal by producing a first and second control output. The first control output is coupled to a switching regulator input, the switching regulator having an output coupled to the control input of the Doherty amplifier. The second control output is coupled to a control input of a variable attenuator. The output of the variable attenuator coupled to the output of the amplifier.

CA 2327137 discloses an amplifier apparatus for a multimode mobile communication device includes a carrier amplifier and a peaking amplifier. The peaking amplifier has an adjustable bias level and is adjusted by a regulator to a predetermined level, depending on which mode of communication is selected. The bias level on the peaking amplifier is held constant so long as the mode of communication is the same. By adjusting the bias point of the peaking amplifier in conjunction with the selection of the mode of communication, the efficiency and the linearity of modulation can be optimized for the particular mode of communication.

### DISCLOSURE OF INVENTION

According to the present invention there is provided a power amplifier as set out at claim 1.

There is a need to overcome the drawbacks of the prior art and to provide at least advantages described hereinafter. In order to solve the above problems pertaining to the previous technology, a specific embodiment of the present invention provides a power amplifier in a mobile handset that improves efficiency and linearity by controlling, for example, input DC-bias voltage applied to a peak amplifier according to the output power levels. Specifically, in the low output power mode, input DC-bias voltage applied to the peak amplifier is controlled so that the power amplifier is operated in the Doherty mode and, in the high output power mode, input DC-bias voltage applied to the peak amplifier is controlled to be increased so as to sufficiently manage the non-linearity characteristic of the power amplifier.

The power amplifier in a mobile handset according to one preferred embodiment of the present invention comprises: a phase difference compensation means, coupled to input terminals of a carrier amplifier and a peak amplifier, for compensating phase difference to equalize phases of output powers from the carrier amplifier and the peak amplifier at an output stage of the power amplifier; an output matching unit for transmitting the output powers from the carrier amplifier and the peak amplifier to the output stage; and a voltage control means for detecting the level of the output power transmitted to the output stage and controlling input DC-bias voltage applied to the peak amplifier in accordance with the detected output power level.

In the preferred embodiment, the phase difference compensation means is implemented with a 3dB hybrid coupler, for example, for distributing certain input powers to the carrier amplifier and the peak amplifier, minimizing interference between the carrier amplifier and the peak amplifier and transmitting signals in such a manner that the phase of input power applied to the peak amplifier is substantially 90° delayed from the phase of input power applied to the carrier amplifier.

Preferably, the phase difference compensation means includes a phase difference compensator, connected in between the input stage of the power amplifier and the peak amplifier, for delaying the phase of input signal applied to the peak amplifier by 90° from the phase of input signal applied to the carrier amplifier.

In the preferred embodiment, the voltage control means comprises: an envelope detector for detecting the level of output power transmitted from the output matching unit to the output stage; a comparison and determination unit for determining by comparison whether the output power level detected by the envelope detector deviates from the low output power range; and a voltage controller for controlling input DC-bias voltage applied to the peak amplifier according to the result of the determination made by the comparison and determination unit.

The voltage control means controls input DC-bias voltage applied to the peak amplifier in such a manner that the power amplifier is operated in the Doherty mode if the level of output power transmitted from the output matching unit to the output stage is within the low output power range. On the other hand, if the level of output power transmitted from the output matching unit to the output stage deviates from the low output power range, the voltage control means controls input DC-bias voltage applied to the peak amplifier in such a manner that the input DC-bias voltage applied to the peak amplifier is increased up to the point satisfying the non-linearity characteristic of the power amplifier.

### BRIEF DESCRIPTION OF THE DRAWINGS

Fig. 1 is a block diagram showing the structure of a power amplifier in a mobile handset in accordance with one preferred embodiment of the present invention.
Fig. 2 shows an equivalent circuit of a 3dB hybrid coupler that can be used in the preferred embodiment of the present invention.
Fig. 3 is a block diagram of an output matching unit illustrated in Fig. 1.
Fig. 4 shows an equivalent circuit of an output matching unit implemented with lumped elements.
Fig. 5 is a graph illustrating efficiency characteristics dependent on input DC-bias voltage applied to a peak amplifier.
Fig. 6 is a graph illustrating non-linearity characteristics dependent on input DC-bias voltage applied to the peak amplifier.
Fig. 7 is a graph illustrating efficiency characteristics corresponding to modes of the power amplifier in accordance with the preferred embodiment of the present invention.
Fig. 8 is a graph illustrating non-linearity characteristics corresponding to modes of the power amplifier in accordance with the preferred embodiment of the present invention.
Fig. 9 is a graph illustrating gain characteristics corresponding to modes of the power amplifier in accordance with the present invention.
Fig. 10 is a block diagram showing the structure of a power amplifier in accordance with a second preferred embodiment of the present invention.

### **Description of the codes at important parts of diagrams**

| | |
|---|---|
| 110: 3dB hybrid coupler | 120: carrier amplifier |
| 130: peak amplifier | 140: output matching unit, |
| 150: envelop detector | 160: digital circuit unit |
| 170: voltage controller | 180: phase difference compensator |

### BEST MODE FOR CARRYING OUT THE INVENTION

Hereinafter, a detailed description will be given with reference to the attached drawings as to an exemplary power amplifier in a mobile handset in accordance with various embodiments of the present invention.

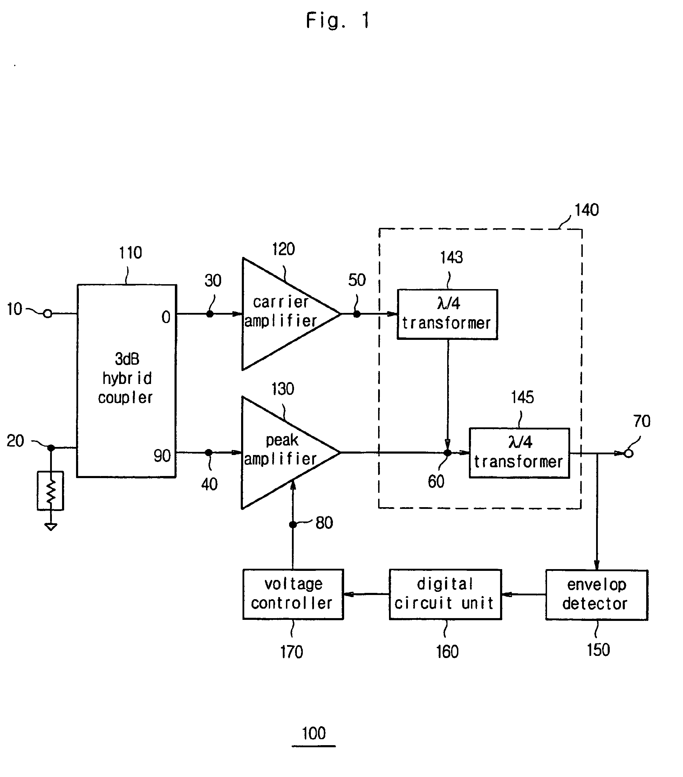

Fig. 1 illustrates the structure of an exemplary power amplifier in a mobile handset in accordance with the first preferred embodiment of the present invention. The power amplifier 100 illustrated in Fig. 1 comprises a 3dB hybrid coupler 110, a carrier amplifier 120, a peak amplifier 130, an output matching unit 140, an envelope detector 150, a digital circuit unit 160 and a voltage controller 170.

The 3dB hybrid coupler 110 distributes certain input powers to the carrier amplifier 120 and the peak amplifier 130, minimizes interference between the carrier amplifier 120 and the peak amplifier 130 and transmits signals in such a manner that the phase of input power of peak amplifier 130 is 90° (λ/4) delayed from the phase of input power of the carrier amplifier 120. Accordingly, the 90° (λ/4) phase delay occurring at the output matching unit 140 between the phases of output powers from the carrier amplifier 120 and the peak amplifier 130 is compensated and the phases of output powers at the output stage are equalized.

As described above, the 3dB hybrid coupler 110's compensation of phase difference between the phases of output powers from the carrier amplifier 120 and the peak amplifier 130 obtains the optimum output power by equalizing the phases of output powers at the output stage.

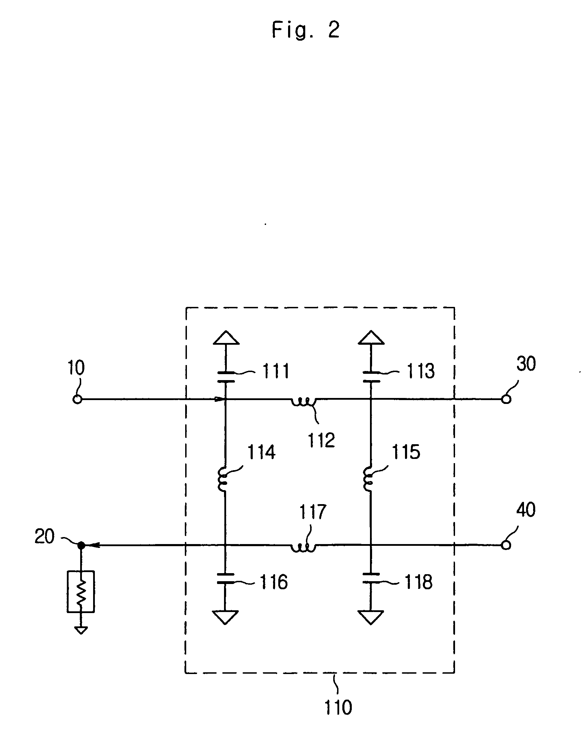

Fig. 2 shows an equivalent circuit of the 3dB hybrid coupler 110 in accordance with the preferred embodiment of the present invention. After signals are inputted into input stage 10 of the 3dB hybrid coupler 110, which has the signal coupling of about 3dB or more, such signals are transmitted to the carrier amplifier output terminal 50 and to the peak amplifier output terminal 60. At this time, the signal outputted to the carrier amplifier output terminal 50 and the signal outputted to the peak amplifier output terminal 60 have a phase difference of 90° (λ/4, or quarter-wave).

As an example, the 3dB hybrid coupler 110 can be implemented with a transmission line, such as a coupled line coupler, a Lange coupler, a branch line coupler or other like coupling circuits known in the art. As another example, the 3dB hybrid coupler 110 may be implemented using a Microwave Monolithic Integrated Circuit (MMIC) chip. In yet another example, the 3dB hybrid coupler 110 may be implemented with lumped elements 111, 112, 113, 114, 115, 116, 117 and 118, as shown in Fig. 2. In still yet another example, the 3dB hybrid coupler 110 may be implemented by the Low Temperature Co-fired Ceramic (LTCC) method.

The carrier amplifier 120 amplifies signals outputted from 3dB hybrid coupler 110 and outputs the amplified signals. The carrier amplifier 120 includes a transistor that can be sized smaller than that of a transistor constituting peak amplifier 130. The ratio of a transistor's size to the other transistor's size, in part, determines an output power range over which the maximum efficiency can be maintained. The higher this ratio, the wider the output power range over which the maximum efficiency can be maintained.

The peak amplifier 130, which is another amplifier for amplifying signals outputted from the 3dB hybrid coupler 110 and outputting the amplified signals, is not substantially operated while low-level input signals are applied to carrier amplifier 120. This is made possible by adjusting the level of input DC-bias voltage applied to peak amplifier 130 in such a way that peak amplifier 130 is biased at class - B or -C, where little DC current flows. Over the low output power range where peak amplifier 130 is not substantially operated, the carrier amplifier 120 has output impedance having a relatively constant and high value. As a result, the carrier amplifier 120 can obtain the maximum efficiency at an output power level which is lower than the highest output power level that carrier amplifier 120 may generate.

The output matching unit 140 includes a first λ/4 transformer 143 for matching impedance of output power applied from carrier amplifier 120 and transmitting the output power applied from the carrier amplifier 120 to the output stage 70; and a second λ/4 transformer 145 for matching impedance of output power applied from the peak amplifier 130 and transmitting the output power applied from the peak amplifier 130 to the output stage 70.

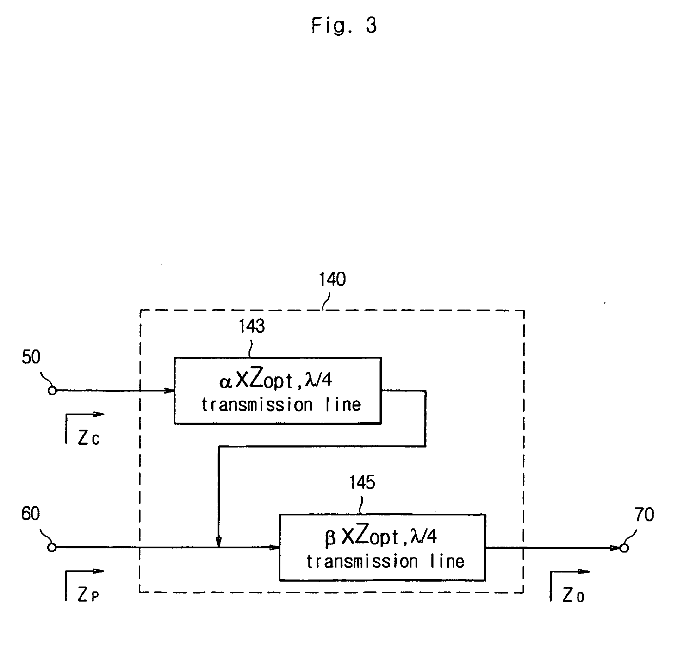

Fig. 3 is a block diagram of the output matching unit 140 illustrated in Fig. 1. By adjusting α and β of the first λ/4 transformer 143 and the second λ/4 transformer 145, in the output matching unit 140, in the low output power range where the peak amplifier 130 is not operated, the carrier amplifier 120 may achieve the maximum efficiency at an output power level which is lower than the highest output power level that the carrier amplifier 120 may generate.

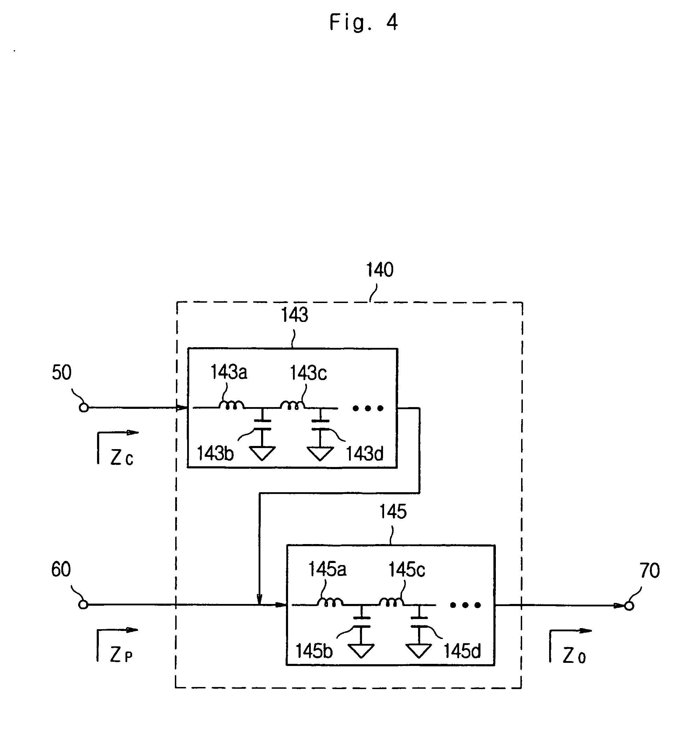

The first λ/4 transformer 143 and the second λ/4 transformer 145 may be implemented with λ/4 transmission lines (T-lines), as shown in Fig. 3, or with lumped elements 143a, 143b, 143c, 143d, ..., 145a, 145b, 145c, 145d, etc., as shown in Fig. 4, or with like elements. Alternatively, the first λ/4 transformer 143 and the second λ/4 transformer 145 may be implemented by the LTCC method.

The envelope detector 150 detects the level of output power transmitted from the output matching unit 140 to output stage 70.

The digital circuit unit 160 is configured to determine whether the output power level detected by the envelope detector 150 deviates from the low output power range Q and applies a control signal to the voltage controller 170 according to the result of the determination.

The voltage controller 170 is configured to control the level of input DC-bias voltage applied to peak amplifier 130 based on the control signal applied from the digital circuit unit 160.

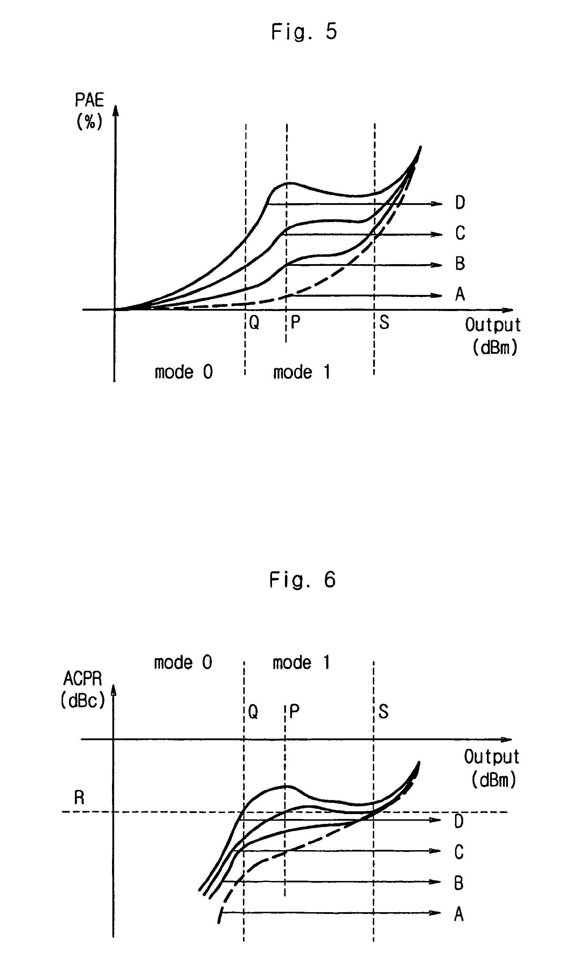

Fig. 5 is a graph illustrating efficiency characteristics as determined by, for example, the input DC-bias voltage applied to peak amplifier 130.

As a current starts to flow in peak amplifier 130, the peak amplifier 130 commences its operation. This changes the output impedance of carrier amplifier 120, thereby optimizing efficiency of power amplifier 100 to a certain constant level as indicated by D in Fig. 5. Accordingly, as indicated by curve D in Fig. 5, the Power Added Efficiency (PAE) has the maximum value from the point P (when the peak amplifier 130 starts to operate) to the point when the power amplifier 100 provides the highest output power. Thus, as illustrated, improved efficiency characteristics are achieved through an exemplary power amplifier, according to an embodiment of the present invention, in comparison with the efficiency characteristic of a general power amplifier indicated by curve A in Fig. 5. As described above, this is made possible by operating the peak amplifier 130 at class -B or -C.

However, illustrated by the graph of Fig. 6 are non-linearity characteristics as an input DC-bias voltage is applied to peak amplifier 130. Values of the overall non-linearity characteristics (as indicated by curve D in Fig. 6) may be difficult to predict and, thus, the non-linear distortion of the power amplifier becomes undesirable. Accordingly, ACPR criterion R, which may be required by a specific system, may not be maintained up to the desired output power level associated with point S.

In other words, as illustrated in Fig. 5 and Fig. 6, compared with general power amplifiers known in the related art, and if the peak amplifier 130 in the power amplifier 100 is operated at class B or C (that is, if the power amplifier 100 is operated in a typical Doherty mode), then power amplifier 100 shows improved efficiency characteristics. However, in terms of linearity, the power amplifier might have less predictable values when operating in the high output power range.

Therefore, an exemplary power amplifier in accordance with an embodiment of the present invention meets high efficiency and linearity requirements in the low output power range, such as at point Q, where the ACPR criterion R required by the system is satisfied. Criterion R is met by setting the input DC bias voltage applied to the peak amplifier 130 in such a way that the peak amplifier 130 can be operated at class -B or -C where little DC current flows, and thus that the power amplifier 100 is operated in the Doherty mode. On the other hand, in the high output power range, the power amplifier achieves excellent linearity by adjusting input DC bias voltage applied to the peak amplifier 130 in such a way that the power amplifier 100 is operated in the operation range (B or A) where the input voltage applied to the peak amplifier 130 is increased up to point R satisfying the non-linearity specification of the power amplifier 100.

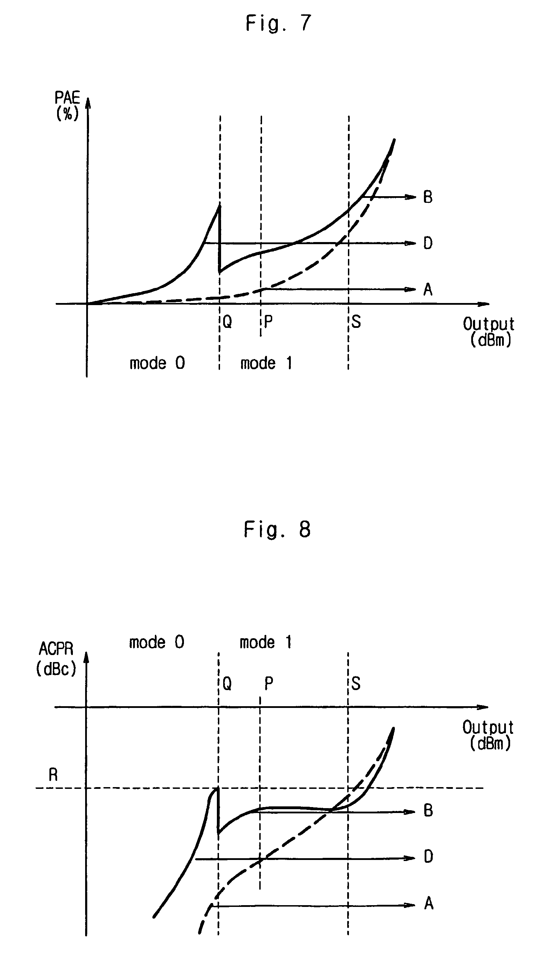

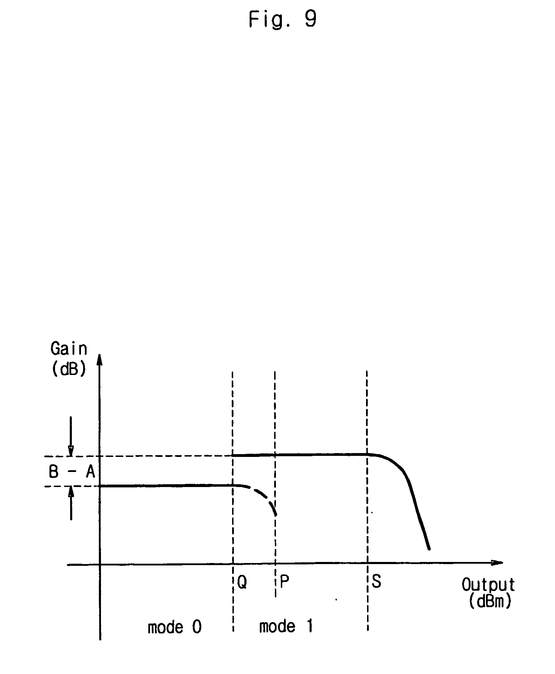

Fig. 7 is a graph illustrating efficiency characteristics corresponding to modes of the power amplifier in accordance with an embodiment of the present invention. Fig. 8 is a graph illustrating non-linearity characteristics corresponding to modes of the power amplifier in accordance with the present invention. Fig. 9 is a graph illustrating gain characteristics corresponding to modes of the power amplifier in accordance with the present invention. In the present invention, the carrier amplifier 120 and the peak amplifier 130 may be operated to have the same linear gain characteristics irrespective of the relevant modes. However, the overall system is not affected even if the carrier amplifier 120 and the peak amplifier 130 are implemented to be operated with different linear gain characteristics according to the relevant modes.

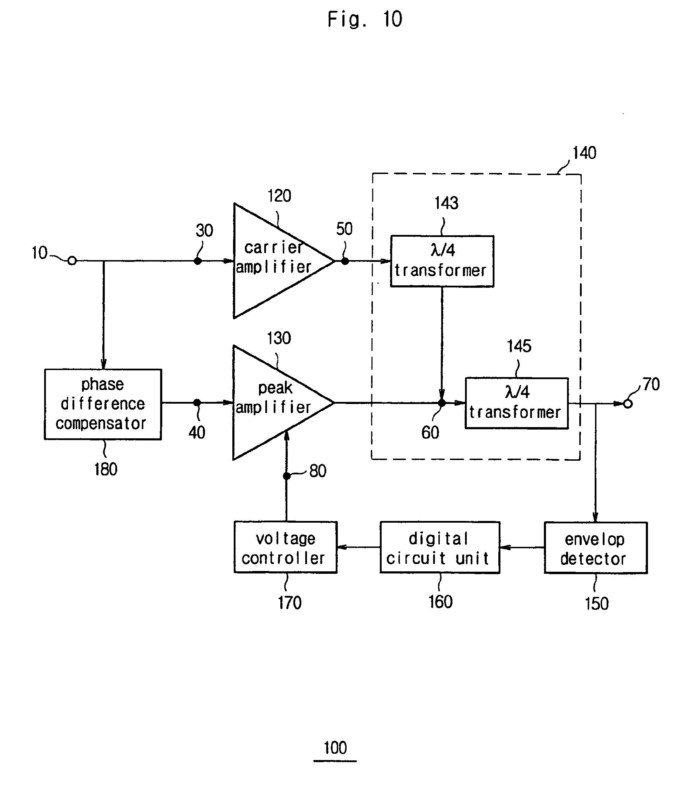

Fig. 10 is a block diagram showing the structure of a power amplifier in a mobile handset in accordance with second preferred embodiment of the present invention. The power amplifier according to the second preferred embodiment of the present invention is substantially the same as the power amplifier 100 of the first preferred embodiment, in terms of the structure and operation. Therefore, the same reference numerals refer to the same parts in the power amplifiers according to the first and the second preferred embodiments. Thus, a detailed description of the power amplifier according to the second preferred embodiment will be omitted herein.

As shown in Fig. 10, another exemplary power amplifier in accordance with second preferred embodiment comprises a phase difference compensator 180 which replaces 3dB hybrid coupler 110 of the first preferred embodiment. The phase difference compensator 180 is connected in between the input stage 10 and the peak amplifier 130 to make input signal applied to the peak amplifier 130 and input signal applied to the carrier amplifier 120 have phase difference of 90° (λ/4).

As described above, because input signal applied to the peak amplifier 130 and input signal applied to the carrier amplifier 120 have a phase difference of 90° (λ/4) through the operation of the phase difference compensator 180, when the output powers from the carrier amplifier 120 and the peak amplifier 130 join in the output matching unit 140, there would be no phase difference and thus the optimum output power may be obtained.

If a phase difference compensator 180 is used instead of the 3dB hybrid coupler 110, the phase difference compensator 180 may be implemented with one simple transmission line. Alternatively, the phase difference compensator 180 may be implemented with lumped elements because the simple transmission line may be approximated to inductance values. In this manner, the power amplifier may be implemented without a complex 3dB hybrid coupler 110 or a large-size transmission line outside of the amplifier. Furthermore, because the phase difference compensator 180 may be integrated within a single chip, the overall size of the power amplifier 100 may be reduced and the price of the power amplifier 100 may also be reduced.

Hereinafter, a detailed description will be given as to the operation of the power amplifier in a mobile handset implemented according to the present invention.

The envelope detector 150 detects the level of output power transmitted to the output stage 70 and supplies the detection result to the digital circuit unit 160. Then, the digital circuit unit 160 determines whether the output power level detected by the envelope detector 150 deviates from the low output power range Q and applies a control signal to the voltage controller 170 in accordance with the result of such determination. If the level of output power transmitted to the output stage 70 is within the low output power range Q (mode 0), the voltage controller 170 controls input DC-bias voltage applied to the peak amplifier 130 in such a manner that the power amplifier 100 is operated in the Doherty mode (i.e., so that the peak amplifier 130 is operated at class -B or -C). In contrast, if the level of output power transmitted to the output stage 70 deviates from the low output power range Q, (namely, in the high output power range) (mode 1), the voltage controller 170 controls input DC-bias voltage applied to the peak amplifier 130 in such a manner that the input DC-bias voltage applied to the peak amplifier 130 is increased so that the ACPR is improved up to point R where the non-linearity specification of the power amplifier 100 is satisfied.

Although several embodiments of the present invention have been disclosed for illustrative purposes, those skilled in the art will appreciate that various modifications, additions and substitutions are possible, without departing from the scope of the invention as disclosed in the accompanying claims.

### INDUSTRIAL APPLICABILITY

As described above, the present invention provides a power amplifier in a mobile handset that improves efficiency and linearity, by controlling an input DC-bias voltage applied to a peak amplifier according to the relevant output power levels. Specifically, in the low output power mode, input DC-bias voltage to the peak amplifier is controlled so that the power amplifier of the present invention is operated in the Doherty mode and, in the high output power mode, input DC-bias voltage to the peak amplifier is controlled to be increased so as to satisfy the non-linearity specification of the power amplifier.

Further, according to the present invention, the power amplifier can be implemented through a simple process, and the size and the price of the power amplifier may be reduced because only input DC-bias voltage applied to the peak amplifier is controlled.

## Claims

1. A power amplifier (100) for a mobile handset, comprising:
a carrier amplifier (120);
a peak amplifier (130);
a phase difference compensation means (110), coupled to an input terminal of the carrier amplifier and an input terminal of the peak amplifier, for compensating a phase difference by equalizing a phase of a carrier output power signal (50) from the carrier amplifier and of a peak output power signal (60) from the peak amplifier at a power amplifier output stage (70); and
an output matching unit (140) for transmitting the carrier output power signal and the peak output power signal;
**characterised in that** the power amplifier comprises a voltage control means (150, 160, 170) for detecting a level of the power amplifier output power signal (70) transmitted to the power amplifier output stage (70) and controlling an input DC-bias voltage (80) applied to the input of the peak amplifier (130) in accordance with the detected level of the power amplifier output power signal (70).

2. The power amplifier according to claim 1, wherein the phase difference compensation means is a 3dB hybrid coupler for distributing certain input powers to the carrier amplifier and the peak amplifier, minimizing interference between the carrier amplifier and the peak amplifier and transmitting signals in such a manner that a phase of an input power signal applied to the peak amplifier is substantially 90° out-of-phase from a phase of an input power applied to the carrier amplifier.

3. The power amplifier according to claim 2, wherein the 3dB hybrid coupler is implemented by the Low Temperature Co-fired Ceramic (LTCC) method.

4. The power amplifier according to claim 1, wherein the phase difference compensation means includes a phase difference compensator, coupled between an input stage of the power amplifier and the input terminal of the peak amplifier, for delaying the phase of input signal applied to the peak amplifier by 90° from the phase of input signal applied to the input terminal of the carrier amplifier.

5. The power amplifier according to claim 4, wherein the phase difference compensator is implemented with a transmission line.

6. The power amplifier according to either claim 2 or claim 4, wherein the phase difference compensator is implemented with lumped elements.

7. The power amplifier according to claim 1, wherein the output matching unit is implemented by one of the lumped elements and the Low Temperature Co-fired Ceramic (LTCC) method.

8. The power amplifier according to claim 1, wherein the voltage control means comprises:
an envelope detector (150) for detecting the level of the power amplifier output power signal transmitted from the output matching unit to the power amplifier output stage;
a comparison and determination unit (160) for determining by comparison whether the output power level detected by the envelope detector deviates from the low output power range; and
a voltage controller (170) for controlling an input DC-bias voltage applied to the peak amplifier according to the resultant comparison of the determination made by the comparison and determination unit.

9. The power amplifier according to claim 1, wherein the voltage control means is operable:
if the level of power amplifier output power signal transmitted from the output matching unit to the power amplifier output stage is within the low output power range, the voltage control means controls an input DC-bias voltage applied to the peak amplifier in such a manner that the power amplifier is operated in a Doherty amplification mode; and
if the level of power amplifier output power signal transmitted from the output matching unit to the power amplifier output stage deviates from the low output power range, the voltage control means controls input DC-bias voltage applied to the peak amplifier in such a manner that the input DC-bias voltage applied to the peak amplifier is increased up to a point that a non-linearity characteristic of the power amplifier is satisfied.

10. The power amplifier according to claim 1, wherein the carrier amplifier and the peak amplifier have different gain characteristics.

11. A mobile handset comprising a power amplifier (100) according to any preceding claim.

## Patentansprüche

1. Ein Leistungsverstärker (100) für ein mobiles Handgerät, aufweisend:
einen Trägerfrequenzverstärker (120);
einen Spitzenverstärker (130);
ein Phasendifferenzkompensationsmittel (110), das an einen Eingangsanschluss des Trägerfrequenzverstärkers und an einen Eingangsanschluss des Spitzenverstärkers gekoppelt ist, zum Kompensieren einer Phasendifferenz durch Ausgleichen einer Phase eines Trägerfrequenzausgangsleistungssignals (50) von dem Trägerfrequenzverstärker und eines Spitzenausgangsleistungssignals (60) von dem Spitzenverstärker an einer Leistungsverstärkerausgangsstufe (70); und
eine Ausgangsanpassungseinheit (140) zum Übertragen des Trägerfrequenzausgangsleistungssignals und des Spitzenausgangsleistungssignals;
**dadurch gekennzeichnet, dass** der Leistungsverstärker ein Spannungsregelungsmittel (150, 160, 170) zum Detektieren eines Levels des Leistungsverstärkerausgangsleistungssignals (70), das zu der Leistungsverstärkerausgangsstufe (70) übertragen wird, und zum Regeln einer Eingangs-DC-Vorspannung (80), die an den Eingang des Spitzenverstärkers (130) in Übereinstimmung mit dem detektierten Level des Leistungsverstärkerausgangsleistungssignals (70) angelegt wird.

2. Der Leistungsverstärker nach Anspruch 1, wobei das Phasendifferenzkompensationsmittel ein 3dB Hybridkoppler zum Verteilen von bestimmten Eingangsleistungen zu dem Leistungsverstärker und dem Spitzenverstärker, zum Minimieren von Interferenz zwischen dem Trägerfrequenzverstärker und dem Spitzenverstärker und zum Übertragen von Signalen in einer Weise, dass eine Phase eines Eingangsleistungssignals angelegt an den Spitzenverstärker im Wesentlichen 90° phasenverschoben von einer Phase einer Eingangsleistung angelegt an den Trägerfrequenzverstärker ist.

3. Der Leistungsverstärker nach Anspruch 2, wobei der 3dB Hybridkoppler durch das Niedertemperatur-Einbrand-Keramik-Verfahren (Low Temperature Co-fired Ceramic (LTCC)) implementiert ist.

4. Der Leistungsverstärker nach Anspruch 1, wobei das Phasendifferenzkompensationsmittel einen Phasendifferenzkompensator, gekoppelt zwischen einer Eingangsstufe des Leistungsverstärkers und des Eingangsanschlusses des Spitzenverstärkers, aufweist, zum Verzögern der Phase des Eingangssignals angelegt an den Spitzenverstärker um 90° von der Phase des Eingangssignals angelegt an den Eingangsanschluss des Trägerfrequenzverstärkers.

5. Der Leistungsverstärker nach Anspruch 4, wobei der Phasendifferenzkompensator mit einer Übertragungsleitung implementiert ist.

6. Der Leistungsverstärker nach Anspruch 2 oder Anspruch 4, wobei der Phasendifferenzkompensator mit konzentrierten Elementen implementiert ist.

7. Der Leistungsverstärker nach Anspruch 1, wobei die Ausgangsanpassungseinheit durch eine der konzentrierten Elemente oder des Niedertemperatur-Einbrand-Keramik-Verfahrens (LTCC) implementiert ist.

8. Der Leistungsverstärker nach Anspruch 1, wobei das Spannungsregelungsmittel aufweist:
einen Hüllkurvendetektor (150) zum Detektieren des Levels des Leistungsverstärkerausgangsleistungssignals, das von der Ausgangsanpassungseinheit zu der Leistungsverstärkerausgangsstufe übertragen wird;
eine Vergleichs- und Ermittlungseinheit (160) zum Ermitteln durch Vergleich, ob der Ausgangsleistungslevel detektiert durch den Hüllkurvendetektor von dem Niedrigausgangsleistungsbereich abweicht; und
einen Spannungsregler (170) zum Regeln einer Eingangs-DC-Vorspannung angelegt an den Spitzenverstärker entsprechend dem resultierenden Vergleich der Ermittlung erstellt durch die Vergleichs- und Ermittlungseinheit.

9. Der Leistungsverstärker nach Anspruch 1, wobei das Spannungsregelungsmittel betreibbar ist:
wenn der Level des Leistungsverstärkerausgangsleistungssignals übertragen von der Ausgangsanpassungseinheit zu der Leistungsverstärkerausgangsstufe innerhalb des Niedrigausgangsleistungsbereichs ist, regelt das Spannungsregelungsmittel eine Eingangs-DC-Vorspannung angelegt an den Spitzenverstärker in einer Weise, dass der Leistungsverstärker in einem Doherty-Verstärkungsmodus betrieben ist; und
wenn der Level des Leistungsverstärkerausgangsleistungssignals übertragen von der Ausgangsanpassungseinheit zu der Leistungsverstärkerausgangsstufe von dem Niedrigausgangsleistungsbereich abweicht, regelt das Spannungsregelungsmittel eine Eingangs-DC-Vorspannung angelegt an den Spitzenverstärker in einer Weise, dass die Eingangs-DC-Vorspannung angelegt an den Spitzenverstärker bis zu einem Punkt ansteigt, dass eine Nichtlinearitätscharakteristik des Leistungsverstärkers erfüllt ist.

10. Der Leistungsverstärker nach Anspruch 1, wobei der Trägerfrequenzverstärker und der Spitzenverstärker unterschiedliche Verstärkungscharakteristika haben.

11. Ein mobiles Handgerät aufweisend einen Leistungsverstärker (100) nach einem der vorhergehenden Ansprüche.

## Revendications

1. Amplificateur de puissance (100) pour un combiné téléphonique mobile, comprenant :
un amplificateur de courant porteur (120) ;
un amplificateur de crête (130) ;
un moyen de compensation de différence de phase (110) couplé à une borne d'entrée de l'amplificateur de courant porteur et une borne d'entrée de l'amplificateur de crête, afin de compenser une différence de phase en égalisant une phase d'un signal de puissance de sortie de courant porteur (50) provenant de l'amplificateur de courant porteur et un signal de puissance de sortie de crête (60) provenant de l'amplificateur de crête au niveau d'un étage de sortie d'amplificateur de puissance (70) ; et
une unité d'adaptation de sortie (140) permettant de transmettre le signal de puissance de sortie de courant porteur et le signal de puissance de sortie de crête ;
**caractérisé en ce que** l'amplificateur de puissance comprend un moyen de contrôle de tension (150, 160, 170) permettant de détecter un niveau du signal de puissance de sortie de l'amplificateur de puissance (70) transmis à l'étage de sortie de l'amplificateur de puissance (70) et pour contrôler une tension de polarisation CC d'entrée (80) appliquée à l'entrée de l'amplificateur de crête (130) selon le niveau détecté du signal de puissance de sortie de l'amplificateur de puissance (70).

2. Amplificateur de puissance selon la revendication 1, dans lequel le moyen de compensation de différence de phase est un coupleur hybride 3 dB permettant de répartir certaines puissances d'entrée sur l'amplificateur de courant porteur et l'amplificateur de crête, réduire au minimum l'interférence entre l'amplificateur de courant porteur et l'amplificateur de crête et transmettre les signaux de telle manière qu'une phase d'un signal de puissance d'entrée appliquée à l'amplificateur de crête est sensiblement déphasée de 90° par rapport à une phase d'une puissance d'entrée appliquée à l'amplificateur de courant porteur.

3. Amplificateur de puissance selon la revendication 2, dans lequel le coupleur hybride de 3 dB est mis en oeuvre grâce au procédé de céramique cocuite à basse température (LTCC).

4. Amplificateur de puissance selon la revendication 1, dans lequel le moyen de compensation de différence de phase inclut un compensateur de différence de phase, couplé entre un étage d'entrée de l'amplificateur de puissance et la borne d'entrée de l'amplificateur de crête, permettant de retarder la phase du signal d'entrée appliquée à l'amplificateur de crête de 90° par rapport à la phase de signal d'entrée appliquée à la borne d'entrée de l'amplificateur de courant porteur.

5. Amplificateur de puissance selon la revendication 4, dans lequel le compensateur de différence de phase est mis en oeuvre avec une ligne de transmission.

6. Amplificateur de puissance selon la revendication 2 ou la revendication 4, dans lequel le compensateur de différence de phase est mis en oeuvre avec des éléments localisés.

7. Amplificateur de puissance selon la revendication 1, dans lequel l'unité d'adaptation de sortie est mise en oeuvre par l'un des éléments localisés et le procédé de céramique cocuite à basse température (LTCC).

8. Amplificateur de puissance selon la revendication 1, dans lequel le moyen de contrôle de tension comprend :
un détecteur d'enveloppe (150) permettant de détecter le niveau du signal de puissance de sortie de l'amplificateur de puissance transmis entre l'unité d'adaptation de sortie et l'étage de sortie de l'amplificateur de puissance ;
une unité de comparaison et de détermination (160) permettant de déterminer par comparaison si le niveau de puissance de sortie détecté par le détecteur d'enveloppe dévie de la plage de puissances de sortie basse ; et
un contrôleur de tension (170) permettant de contrôler une tension de polarisation CC d'entrée appliquée à l'amplificateur de crête selon la comparaison résultante de la détermination effectuée par l'unité de comparaison et de détermination.

9. Amplificateur de puissance selon la revendication 1, dans lequel le moyen de contrôle de tension peut fonctionner :
si le niveau du signal de puissance de sortie de l'amplificateur de puissance transmis entre l'unité d'adaptation de sortie et l'étage de sortie de l'amplificateur de puissance se trouve dans les limites de la plage de puissances de sortie faible, le moyen de contrôle de tension contrôle une tension de polarisation CC d'entrée appliquée à l'amplificateur de crête, de telle manière que l'amplificateur de puissance peut fonctionner en mode d'amplification de Doherty ; et
si le niveau du signal de puissance de sortie de l'amplificateur de puissance transmis entre l'unité d'adaptation de sortie et l'étage de sortie de l'amplificateur de puissance dévie de la plage de puissances de sortie faible, le moyen de contrôle de tension contrôle la tension de polarisation CC d'entrée appliquée à l'amplificateur de crête, de telle manière que la tension de polarisation CC d'entrée appliquée à l'amplificateur de crête augmente jusqu'à un point tel qu'une caractéristique de non-linéarité de l'amplificateur de puissance est satisfaite.

10. Amplificateur de puissance selon la revendication 1, dans lequel l'amplificateur de courant porteur et l'amplificateur de crête ont des caractéristiques de gain différentes.

11. Combiné téléphonique mobile comprenant un amplificateur de puissance (100) selon l'une quelconque des revendications précédentes.
